# EUROPEAN PATENT APPLICATION

(11) **EP 4 723 839 A1**
(43) Date of publication of application: **08.04.2026**
(21) Application number: 24204873.4
(22) Date of filing: 07.10.2024
(51) Int. Cl.: H10F 30/221, H10F 30/222, H10F 77/14, H10F 77/00, H10F 39/12

(54) **A DEVICE FOR LIGHT DETECTION, AN IMAGE SENSOR, AND A METHOD FOR LIGHT DETECTION**

(71) Applicant: Imec VZW, 3001 Leuven (BE)
(72) Inventor: LEE, Jiwon, 3020 Herent (BE)
(74) Representative: AWA Sweden AB

(57) **Abstract**

A device (100; 200; 300; 400) for light detection comprises: an active layer (110; 210; 310; 410) configured to generate electrons in response to incident light; a silicon layer (120; 220; 320; 420) comprising a diode arrangement (122) configured for collection of the electrons generated by the active layer (110; 210; 310; 410); and an interface layer (140; 240; 340; 440) arranged between the active layer (110; 210; 310; 410) and the silicon layer (120; 220; 320; 420), wherein the interface layer (140; 240; 340; 440) is configured to provide an alignment of a conduction band of electrons between an energy level of the active layer (110; 210; 310; 410) and an energy level of the silicon layer (120; 220; 320; 420) for facilitating transport of the generated electrons from the active layer (110; 210; 310; 410) to the silicon layer (120; 220; 320; 420).

## Description

### Technical field

The present description relates to a device and a method for light detection. In particular, the present description relates to light detection that is suited for sensing a broad range of wavelengths. The present description also relates to an image sensor enabling imaging in a broad range of wavelengths.

### Background

Using silicon in light detection sets limits to the wavelengths that may be detected, based on optical characteristics of silicon. Therefore, it is of interest to use other materials in light detection. In this regard, light detecting units that may be formed using thin-film technology is interesting, since such light detecting units could be monolithically integrated on semiconductor substrates to still make use of the semiconductor substrate to provide circuitry for read-out and processing of signals from the light detecting units.

However, read-out of light detection from light detecting units using thin-film technology has inferior signal-to-noise ratio compared to image sensors formed in silicon. Therefore, there is a need for improvement of light detection based on other materials than silicon for enabling read-out the light detection with an improved signal-to-noise ratio.

### Summary

An objective of the present description is to provide light detection with a high signal-to-noise ratio. In particular, it is an objective of the present description to provide light detection with a high signal-to-noise ratio for wavelengths which cannot be detected by a silicon-based light detector.

These and other objectives are at least partly met by the invention as defined in the independent claims. Preferred embodiments are set out in the dependent claims.

According to a first aspect, there is provided a device for light detection, wherein the device comprises: an active layer configured to generate electrons in response to incident light on the active layer; a silicon layer comprising a diode arrangement configured for collection of the electrons generated by the active layer; an interface layer arranged between the active layer and the silicon layer, wherein the interface layer is configured to provide an alignment of a conduction band of electrons between an energy level of the active layer and an energy level of the silicon layer for facilitating transport of the generated electrons from the active layer to the silicon layer.

The device for light detection provides detection of incident light in the active layer by generating electrons in response to incident light. The generated electrons form a representation of intensity of incident light. The device is further configured to collect electrons in the diode arrangement of the silicon layer such that the generated electrons are efficiently collected. Thus, there is a high efficiency in collected electrons in that a relation between a number of collected electrons in the diode arrangement and intensity of incident light is high.

The device may be configured to accumulate electrons in the diode arrangement during a period of time. The accumulation of electrons may correspond to an integration time of the device, wherein the collected electrons in the diode arrangement may represent an intensity of incident light during the integration time.

The incident light should not be construed narrowly to relate to light in a visible range. Rather, light may refer to electro-magnetic radiation in a broad spectrum, including ultraviolet light, visible light, and infrared light. The active layer may be sensitive to one or more wavelength ranges within the broad spectrum.

The active layer may make use of materials suited for the detection of a desired wavelength and is not limited to wavelengths for which silicon is sensitive. The device further makes use of a silicon layer for enabling read-out of information of detected light in a silicon-based read-out circuitry.

Thanks to the interface layer, the generated electrons may be efficiently transported from the active layer to the diode arrangement in the silicon layer. The interface layer therefore enables the use of the active layer for detecting light to be combined with read-out through a diode arrangement in a silicon layer. Thus, the light detected in the active layer need not be associated with a read-out that is not provided in a silicon structure.

The interface layer thus ensures combination of the active layer with the diode arrangement in the silicon layer. This implies that a high signal-to-noise ratio may be achieved, since the read-out of the light detected by the active layer is provided in the silicon layer using mature silicon technology.

The active layer may be formed by a photo-absorbing material or a stack of materials including a photo-absorbing material. The photo-absorbing material may thus be configured to absorb incident light on the active layer and to generate electrons in response to the incident light. The photo-absorbing material may further be configured to generate holes in response to the incident light. The electrons are transported to the silicon layer for read-out of information of the detected incident light.

The active layer may further be associated with further layers, which may be formed in a stack of layers for controlling generation of electrons in the active layer and for transporting of charges from the active layer. The stack of layers may include electrodes providing control of potentials within the stack of layers.

The active layer may be configured to extend along the silicon layer. The interface layer may also be configured to extend along the silicon layer. The silicon layer, the interface layer and the active layer may thus form a stacked configuration with the interface layer arranged between the silicon layer and the active layer. The silicon layer, the interface layer and the active layer may be formed in separate, parallel planes.

The active layer may have a relatively large extension in a direction along the silicon layer and may have a small thickness in a direction perpendicular to the extension along the silicon layer. Thus, the active layer may be referred to as a thin film.

Similarly, the interface layer may have a relatively large extension in a direction along the silicon layer and may have a small thickness in a direction perpendicular to the extension along the silicon layer.

The active layer may be arranged to face a direction from which light is incident on the device. Thus, light may be incident on the active layer without passing through the interface layer or the silicon layer before reaching the active layer.

The silicon layer may be formed by a silicon substrate which may have a very large extension in a direction along the layer. The silicon layer may be formed by monocrystalline silicon.

The silicon layer may be utilized by a plurality of devices for light detection, such that the silicon layer may be shared by a plurality of devices arranged in an array. The diode arrangement may be specific to a single device, but the silicon layer may comprise a plurality of diode arrangements for a plurality of devices. The active layer and the interface layer may be arranged on the diode arrangement such that a projection of the active layer and the interface layer onto the silicon layer coincides with a location of the diode arrangement in the silicon layer.

The silicon layer comprises a diode arrangement. The diode arrangement may be configured to control charges to be conducted in a single direction in the diode arrangement. This may be achieved using regions in the silicon layer that have different doping.

The diode arrangement may comprise a p-n junction between two regions being differently doped, one region being positively doped by holes and one region being negatively doped by electrons. The doped regions may be formed in a surface of a silicon substrate forming the silicon layer, e.g., by ion implantation or diffusing of dopants. The doped regions may alternatively or additionally be formed by growing layers of crystals with different doping at the surface of the silicon substrate. The diode arrangement may comprise a structure corresponding to a photodiode, although the diode arrangement need not be used for generating charges based on incident light on the photodiode. Rather, the diode arrangement may only be used for controlling transfer of electrons generated by light being incident on the active layer.

The diode arrangement may comprise a structure corresponding to a pinned photodiode, wherein a highly positively doped region is provided on a p-n junction. This may permit efficient charge transfer from an area in which charges are collected for read-out of a signal representative of incident light and also provides low noise.

The diode arrangement may be controlled by a control signal for causing transfer of collected charges through the diode arrangement to a node for read-out the electrons generated by the active layer and transported to the silicon layer. The diode arrangement may comprise a potential barrier preventing electrons transported from the active layer to the silicon layer to be immediately transported to the node for read-out. This potential barrier may be lowered based on the control signal for causing the transfer of electrons to the node for read-out.

The interface layer may ensure that an energy level of a conduction band of electrons experienced by electrons being transported from the active layer to the silicon layer follows a decreasing function or almost exclusively decreasing function from the active layer to the silicon layer. This implies that the electrons do not experience any large potential barriers with the energy level of the conduction band being exclusively or almost exclusively decreasing and/or partly constant in a path followed by the electrons going from the active layer to the silicon layer. At most, the energy level of the conduction band may increase by a few times of thermal voltage in some location along the path followed by the electrons going from the active layer to the silicon layer. Such an increase would not represent a potential barrier preventing the electrons from following the path, since the electrons would be able to overcome the increase in the energy level of the conduction band.

As used herein, an energy level of a layer refers to an energy level of the conduction band of electrons in the layer. The alignment of the conduction band of electrons between an energy level of the active layer and an energy level of the silicon layer implies that the interface layer provides an energy level of the conduction band of electrons at a surface of the interface layer facing the active layer, wherein the energy level at the surface of the interface layer is higher than the energy level of the silicon layer. Thus, the difference between the energy level of the active layer and the surface of the interface layer is smaller than the difference between the energy level of the active layer and the surface of the silicon layer. This implies that the energy level of the conduction band in a direction from the active layer to the silicon layer is smoother, with smaller or no discrete steps, compared to no interface layer being present between the silicon layer and the active layer. This implies that the interface layer may ensure that no potential barriers or only small increases in the energy level of the conduction band are provided for the electrons in the path of the electrons going from the active layer to the silicon layer. Thus, by the conduction band of the electrons being aligned, potential barriers that prevent electrons from being transported from the active layer to the silicon layer may be avoided in any interface between different materials or different regions in the path of the electrons going from the active layer to the silicon layer. If an increase of the energy level of the conduction band is included in the path, such an increase of an energy level of the conduction band of electrons experienced by the electrons may not be larger than a few times a thermal voltage, such as 5 times a thermal voltage, such as 3 times a thermal voltage, at a temperature of 25°C.

The alignment of the conduction bands of electrons imply that the electrons generated by the active layer will drift from the active layer to the silicon layer. The electrons may further be stored in the diode arrangement during the integration time.

It should be realized that the device may comprise further layers between the silicon layer or the active layer, on a side of the silicon layer facing away from the active layer, or on a side of the active layer facing away from the silicon layer. However, regardless of arrangement of further layers, the device may be configured such that an energy level of a conduction band of electrons experienced by electrons being transported from the active layer to the silicon layer follows a decreasing function from the active layer to the silicon layer.

The interface layer may additionally be configured to passivate a surface of the silicon layer. This implies that a surface state density of the surface of the silicon layer may be reduced. The interface layer may provide passivation of the surface of the silicon layer without introducing potential barriers preventing the electrons from being transported from the active layer to the silicon layer, i.e., any increase of the energy level of the conduction band is not be larger than a few times of the thermal voltage.

According to an embodiment, the interface layer comprises a passivation layer formed by hydrogenated amorphous silicon.

The passivation layer formed by hydrogenated amorphous silicon may passivate the surface of the silicon layer. The hydrogenated amorphous silicon may thus reduce surface state density of the surface of the silicon layer providing a surface interface having a good quality with low surface state density. This enables alignment of the conduction band of electrons to other layers.

The hydrogen-rich passivation layer may reduce trap states and defect density in relation to the surface of the silicon layer. Hence, trap-assisted thermal generation of electrons may be avoided such that a dark current of the device may be low. In addition, recombination of electrons with holes is avoided allowing a high efficiency in light detection.

The passivation layer may be formed directly on a surface of the silicon layer facing the active layer. Thus, the passivation layer may be formed in contact with the silicon layer.

According to an embodiment, the interface layer further comprises an additional passivation layer between the passivation layer and the active layer.

The additional passivation layer may be further configured to passivate the surface of the silicon layer, so as to reduce surface state density of the surface of the silicon layer providing a surface interface having a good quality with low surface state density.

The additional passivation layer may also be configured to improve alignment of the conduction band of electrons to the energy level of the active layer. The additional passivation layer may provide an energy level of the conduction band at a surface facing the active layer which is higher than an energy level of the conduction band at a surface of the passivation layer and the surface of the silicon layer. Thus, the energy level of a surface of the interface layer the additional passivation layer may be close to the energy level of the conduction band in the active layer facilitating alignment of the conduction band of electrons.

According to an embodiment, the device further comprises an electron transport layer between the active layer and the interface layer, wherein the electron transport layer is configured to facilitate transport of electrons from the active layer towards the interface layer.

The electron transport layer may be formed by an n-type material.

The electron transport layer may be configured to transport electrons very quickly. The electron transport layer may be configured to transport electrons from a surface of the active layer to a surface of the interface layer. The electron transport layer may thus be sandwiched between the active layer and the interface layer.

The electron transport layer may thus ensure that electrons are efficiently and quickly transported to the silicon layer. However, it should be realized that the device need not necessarily include the electron transport layer. Rather, the interface layer may in itself provide relatively fast transport of electrons such that the electron transport layer may not be needed.

The electron transport layer may be configured to transport electrons in a direction across an extension of the electron transport layer. Thus, the electrons may be transported in the electron transport layer from a surface facing the active layer to a surface facing the interface layer.

The additional passivation layer may also function as an electrode transport layer. Thus, a single layer may be provided for achieving additional passivation and electrode transport.

In addition, an additional layer arranged between the active layer and the passivation layer may provide a negative type (n-type) region facing the active layer for forming a p-n junction between the active layer and the additional layer. The additional passivation layer and/or the electrode transport layer may also function to provide the p-n junction in combination with the active layer.

The additional layer, which may function as an additional passivation layer and/or an electrode transport layer and/or an n-type region for a p-n junction may comprise titanium oxide, zinc magnesium oxide, [6,6]-phenyl-C61-butyric acid methyl ester (PCBM), zinc oxide, or tin oxide.

According to an embodiment, the passivation layer comprises a first layer facing the active layer formed by hydrogenated amorphous silicon having a first level of n-doping and a second layer formed by hydrogenated amorphous silicon being intrinsic or having a second level of n-doping smaller than the first level, wherein the first layer is between the second layer and the active layer.

The device may comprise a p-n junction forming a photodiode in the device. The p-n junction may drive electrons generated in the active layer towards the silicon layer.

The p-n junction may be formed between the active layer and the interface layer. Thus, the first layer of the hydrogenated amorphous silicon may be used for providing a negative type (n-type) region facing the active layer for forming the p-n junction.

The first and second layers having different doping levels may also or alternatively be used for ensuring a smooth alignment of the conduction band. Thus, the first layer being n-doped may provide an energy level of the conduction band higher than an energy level of the conduction band of the second layer. This may ensure a smooth alignment to the energy level of the active layer.

According to an embodiment, the active layer comprises quantum dots, a perovskite material, or an organic semiconductor.

The device may thus utilize an active layer formed by materials that may be suited for light detection of various wavelengths. The active material to be used in the device may be selected in dependence of the desired wavelengths of light to be detected.

The use of quantum dots, perovskite materials or organic semiconductors in the device enables detection of light within a broad range of wavelengths.

According to an embodiment, the active layer comprises a first layer and a second layer, wherein the second layer is configured to face the interface layer, wherein the first layer comprises a p-type material and the second layer comprises an n-type material for forming a p-n junction between the first layer and the second layer.

The p-n junction may form a photodiode in the device. The p-n junction may drive electrons generated in the active layer towards the silicon layer.

The p-n junction may be formed in the active layer using the first layer of p-type material and the second layer of n-type material. It should further be realized that the p-n junction may be formed using different doping types, such that the first layer is provided with p-type doping and the second layer is provided with n-type doping.

According to an embodiment, the silicon layer comprises n-type silicon, a p+-type silicon region at a first surface of the silicon layer facing away from the interface layer, wherein the p+-type silicon region is configured to provide a pinned surface potential of the silicon layer, and a n+-type silicon region at the first surface forming a node for read-out of collected electrons, wherein the n+-type silicon region is separated from the p+-type silicon region and the n-type silicon by a p-type silicon well.

This implies that the silicon layer may be provided with a structure corresponding to a pinned photodiode for controlling accumulation of electrons and transfer of electrons to the node for read-out. The pinned photodiode structure need not be used for generating charges based on absorbing incident light within the pinned photodiode structure. Rather, the pinned photodiode structure may be used for controlling accumulation and transfer of electrons generated based on light incident on the active layer. However, it should be realized that, in some embodiments, the pinned photodiode structure may also be used for generating charges based on absorbing incident light within the pinned photodiode structure.

The device may thus utilize a structure corresponding to a pinned photodiode in the silicon layer which enables read-out of electrons to the node for read-out using a very high signal-to-noise ratio. In particular, in a conventional silicon-based image sensor, the pinned photodiode allows separation of a photodiode from the node for read-out so as to suppress dark current (i.e., a current without any light being absorbed).

The diode arrangement may be configured to provide a region that is fully depleted of majority carriers between a region where electrons are collected and the node for read-out. Thus, the p-type silicon well may be fully depleted, which implies that thermal noise may be avoided or reduced. In addition, the diode arrangement provides fast read-out of electrons to the node for read-out.

The silicon layer may be arranged with the n-type silicon facing the interface layer, such that n-type silicon is provided at an interface between the silicon layer and the interface layer. However, it should be realized that a thin layer of p-type silicon may be arranged at the interface between the silicon layer and the interface layer and hence between the n-type silicon and the interface layer.

As used herein, n-type silicon refers to silicon being provided with negative type extrinsic doping, while p-type silicon refers to silicon being provided with positive type extrinsic doping. Further, as used herein n+-type silicon and p+-type silicon refers to silicon being heavily doped, that is a concentration of dopants being higher compared to n-type silicon and p-type silicon, respectively.

The n+-type silicon may refer to a negative type doping providing a doping density of the n+-type silicon higher than 10¹⁷ cm-³. The p+-type silicon may refer to a positive type doping providing a doping density of the p+-type silicon higher than 10¹⁷ cm-³.

According to an embodiment, the device further comprises read-out circuitry, wherein the read-out circuitry comprises a transfer gate configured to control reset of the diode arrangement and transfer of charges from the n-type silicon to the n+-type silicon region.

The read-out circuitry may be formed in the silicon layer. The device may utilize read-out circuitry similar to or identical to read-out circuitry used for light detection using photodiodes formed in silicon. Thus, the device may utilize mature technology for designing and producing the read-out circuitry.

The transfer gate may be used for controlling transfer of charges to the node for read-out formed by the n+-type silicon region. The node for read-out may further be connected to or form part of the read-out circuitry in a conventional manner for reading out and processing signals related to light detection.

According to an embodiment, the device further comprises a transparent electrode above the active layer such that the active layer is arranged between the transparent electrode and the silicon layer.

As mentioned above, the device may comprise a p-n junction forming a photodiode in the device. The transparent electrode may provide a low potential at a cathode side of the p-n junction. Further, the n-type silicon may be biased positively by resetting the n-type silicon to a high voltage, for providing a reverse bias of the p-n junction. The reverse bias across the p-n junction may cause a depletion region in the p-n junction, wherein the depletion region is depleted of charge carriers. This facilitates charges generated based on illuminated light being transported from the p-n junction, such that the charges may be efficiently collected for forming a signal representing incident light.

The electrode may be transparent to the wavelengths of light to be detected by the device. Thus, the electrode need only be transparent to relevant wavelengths. For instance, if the device is to be used for detecting infrared light, the transparent electrode may be transparent to infrared light but does not need to be transparent to visible light.

According to an embodiment, the device is configured to detect light by backside illumination.

The read-out circuitry may be provided at a surface of the silicon layer facing away from the active layer. The read-out circuitry may further be associated with wiring layers providing electrical connection to the read-out circuitry.

The device being configured to detect light by backside illumination implies that the incident light will be incident from a backside of the silicon layer, i.e., an opposite side to the side on which the wiring layers are provided. In other words, the device is configured to receive incident light at the active layer such that the light is incident into the active layer from a surface of the active layer facing away from the silicon layer.

The device being configured for backside illumination may thus be configured to detect light without the light passing the wiring layers. This implies that a larger proportion of incident light may be detected compared to frontside illumination. Backside illumination is thus advantageously used for detecting light with a high signal-to-noise ratio.

Also, backside illumination facilitates providing a large area direct connection between the active layer and the silicon layer. This is because the active layer need to be integrated to the silicon layer after processing of back-end-of-line (BEOL) metal layers, since the active layer needs to be processed at a low temperature (about 100 - 200 °C). Thus, by the device being configured to use backside illumination, the active layer may be able to be directly integrated with the silicon layer with no metal layers between the silicon layer and the active layer.

According to an embodiment, the active layer is sensitive for detection of light in short-wavelength infrared (SWIR) range.

Silicon is not sensitive to light in the SWIR range. Hence, for light detection in the SWIR range, a light sensitive element may not be formed in silicon. The device may be advantageously used for detecting light in the SWIR range, since the device enables detection of light in wavelengths for which silicon is not sensitive.

According to a second aspect, there is provided an image sensor, comprising an array of light detecting units, wherein each of a plurality of light detecting units in the array is formed by the device according to the first aspect.

Effects and features of this second aspect are largely analogous to those described above in connection with the first aspect. Embodiments mentioned in relation to the second aspect are largely compatible with the first aspect.

The array may be a one-dimensional or two-dimensional array. The light detecting units may be arranged in a regularly ordered manner in the array. For instance, the light detecting units may be arranged in rows and columns of the array.

Thanks to using an array of light detecting units, the image sensor may thus be configured to acquire information in one or two dimensions. This enables an image to be formed based on the acquired information.

It should be realized that the plurality of light detecting units formed by devices according to the first aspect may correspond to all light detecting units in the array. Thus, the image sensor may be formed by a single type of light detecting units.

However, it should further be realized that the active layer need not be formed by a same material or by a material with the same characteristics in each of the plurality of light detecting units. This implies that different devices in the plurality of light detecting units may be adapted for detection of light of different wavelengths. Thus, the light detecting units in the plurality of light detecting units may be configured to detect light of two or more wavelengths or wavelength ranges. This implies that the plurality of light detecting units may provide spectral resolution of the image sensor.

According to an embodiment, the array of light detecting units further comprises a plurality of visible light detecting units, wherein each visible light detecting unit comprises a photodiode formed in a silicon layer for detecting visible light.

Thus, the image sensor may comprise light detecting units of different types. The image sensor may comprise light detecting units making use of a photodiode formed in the silicon layer and may also comprise light detecting units making use of the device according to the first aspect.

Thus, the device according to the first aspect may be combined within conventional light detecting units in the image sensor. This implies that the image sensor may utilize conventional and mature technology for detecting visible light. In addition, the light detecting units comprising devices according to the first aspect enables light detection in wavelengths for which silicon is not sensitive. Thus, the light detecting units and the visible light detecting units may complement each other for providing an image sensor with a high spectral resolution.

The light detecting units comprising devices according to the first aspect and the visible light detecting units may be arranged in an intermixing manner in the array. Thus, groups may be formed in the array, wherein each group may be defined by a set of one or more light detecting units and one or more visible light detecting units arranged adjacent to each other. Each group may be formed by an identical set and the groups may be repeated across rows and columns of the array. This may be used for providing an image sensor with a spatial and spectral resolution.

For instance, each group may be formed by one light detecting unit comprising a device according to the first aspect adapted for detecting light in the SWIR range and three visible light detecting units adapted for detecting light in three different ranges of visible light. This may be used for acquiring an image wherein pixels are provided with a spectral resolution of red, green, and blue light as well as infrared light.

According to a third aspect, there is provided a method for light detection, said method comprising: generating electrons in an active layer in response to incident light on the active layer; transferring the electrons through an interface layer to a silicon layer; collecting the electrons in a diode arrangement in the silicon layer; wherein the interface layer is configured to provide an alignment of a conduction band of electrons between an energy level of the active layer and an energy level of the silicon layer for facilitating transport of the generated electrons from the active layer to the silicon layer.

Effects and features of this third aspect are largely analogous to those described above in connection with the first and second aspects. Embodiments mentioned in relation to the third aspect are largely compatible with the first and second aspects.

Thanks to the method, light may be detected in an active layer which may be adapted to be sensitive to light within a broad range of wavelengths, such as including infrared light. The electrons are further transferred to a diode arrangement in silicon layer via an interface layer such that electrons may be efficiently transported to the diode arrangement. In particular, the electrons may not be transported via the interface layer such that the electrons do not experience any potential barriers in a path followed by the electrons going from the active layer to the silicon layer.

### Brief description of the drawings

The above, as well as additional objects, features, and advantages of the present description, will be better understood through the following illustrative and non-limiting detailed description, with reference to the appended drawings. In the drawings like reference numerals will be used for like elements unless stated otherwise.
Fig. 1 is a schematic cross-sectional view of a device for light detection according to a first embodiment.
Fig. 2 is a schematic graph of an energy level of a conduction band of electrons along line a-a' in Fig. 1.
Fig. 3 is a schematic graph of an energy level of a conduction band of electrons within the silicon layer along line b-b' in Fig. 1, illustrating in a left part of Fig. 3 the energy level when a transfer gate is off, and illustrating in a right part of Fig. 3 the energy level when a transfer gate is on.
Fig. 4 is a schematic cross-sectional view of a device for light detection according to a second embodiment.
Fig. 5 is a schematic cross-sectional view of a device for light detection according to a third embodiment.
Fig. 6 is a schematic cross-sectional view of a device for light detection according to a fourth embodiment.
Fig. 7 is a schematic view of a read-out circuitry of the device according to any of the embodiments.
Fig. 8 is an operational timing diagram related to the read-out circuitry.
Fig. 9 is a schematic cross-sectional view of an image sensor according to a first embodiment.
Fig. 10 is a schematic cross-sectional view of an image sensor according to a second embodiment.
Fig. 11 is a flow chart of a method according to an embodiment.

### Detailed description

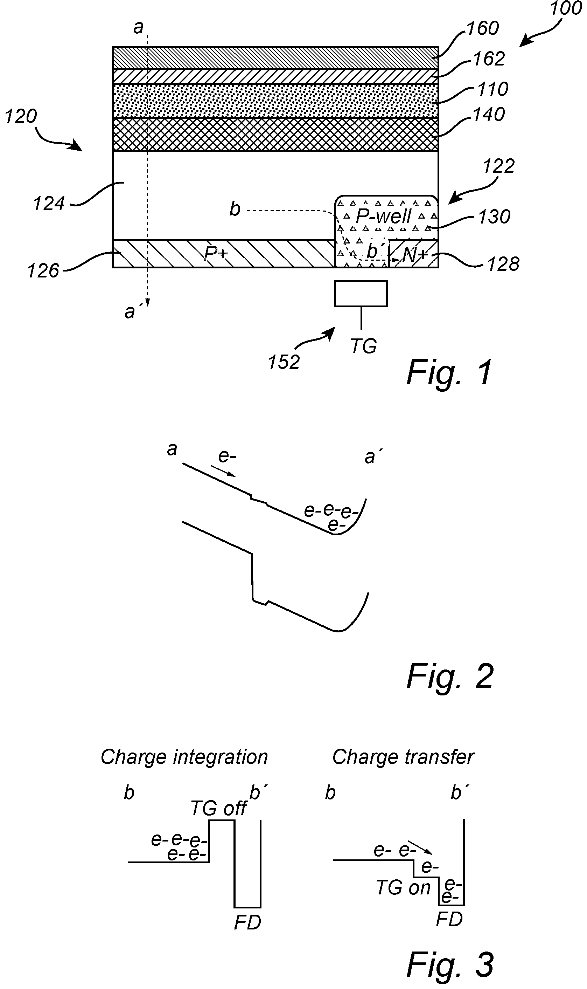

Referring now to Fig. 1, a device 100 for light detection according to an embodiment will be described.

The device 100 comprises a stack of layers configured to provide light detection and collection of charges generated by the light detection. The layers may be arranged stacked on each other, such that each layer may have a relatively large extension in an area of the layer. Each layer may have two opposing surfaces defining a thickness of the layer between the surfaces. Further, the layers are stacked on each other such that surfaces of adjacent layers form an interface between the layers.

The device 100 is shown in Fig. 1 with a topmost layer of the stack of layers facing a direction from which light to be detected is incident. A layer may be referred to another layer as being "on" or "below" the other layer, referring to the orientation shown in Fig. 1. However, it should be realized that the device 100 need not necessarily be oriented in the manner shown in Fig. 1 and a reference to "on", "below", "top", or "bottom" should not be construed as the device 100 necessarily being provided in the orientation shown in Fig. 1. In addition, a layer being on or below another layer does not necessarily mean that the layer is immediately on or below the other layer. Rather, there may be intermediate layers in-between.

The device 100 comprises an active layer 110 configured to generate electrons in response to incident light on the active layer 110. The active layer 110 may form part of a photodetection material stack, forming a stack of layers adapted for photodetection. The photodetection material stack may further comprise a transparent conductive electrode 160 on the active layer 110 and a hole transport layer 162 between the transparent conductive electrode 160 and the active layer 110.

The conductive electrode 160 may serve to provide a potential such that a voltage is provided across a p-n junction. The p-n junction may be formed in the active layer 110 or in an interface between the active layer 110 and an adjacent layer. The voltage across the p-n junction may form a depletion region in the p-n junction such that charges generated in the p-n junction in response to incident light being absorbed may be swept away from the p-n junction.

The incident light may be absorbed in the active layer 110 to form an electron-hole pair. The hole charges may be transported from the active layer 110 to the hole transport layer 162 and may further be transported away by the hole transport layer 162.

The electrons generated in response to the incident light may be transported in an opposite direction to the hole charges.

The device 100 further comprises a silicon layer 120 comprising a diode arrangement 122 configured to collect electrons generated by the active layer 110. The device also comprises an interface layer 140 arranged between the active layer 110 and the silicon layer 120.

The interface layer 140 may be configured to passivate a surface of the silicon layer 120 facing the active layer 110. This may imply that a surface state density of an interface facing the active layer 110 may be reduced such that a good-quality interface to the photodetection material stack is provided.

The interface layer 140 is configured to provide an alignment of a conduction band of electrons between an energy level of the active layer 110 and an energy level of the silicon layer 120. This may imply that electrons transported from the active layer 110 to the silicon layer 120 may not experience large potential barriers in a path from the active layer 110 to the silicon layer 120. Rather, any increase in the increase of the energy level of the conduction band included in the path may not be larger than a few times a thermal voltage, such as 5 times a thermal voltage, such as 3 times a thermal voltage, at a temperature of 25°C, such that the increase of the energy level may be overcome by electrons transported in the path. Thus, the electrons generated in the active layer 110 in response to incident light may drift to the silicon layer 120 and be collected therein.

The silicon layer 120 is suitable for providing a diode arrangement 122. The diode arrangement 122 may be provided in the silicon layer 120 in accordance with conventional structures. For instance, a diode arrangement 122 corresponding to a structure used as a photodiode may be used. As shown in Fig. 1, the diode arrangement 122 may correspond to a structure of a pinned photodiode.

The silicon layer 120 may be formed by n-type silicon 124, such that the silicon layer 120 provide an n-type silicon region facing the interface layer 140. However, according to some embodiments, a p-type silicon region may be arranged on the n-type silicon region such that the p-type silicon region may face the interface layer 140. The diode arrangement comprises a p+-type silicon region 126 at a first surface of the silicon layer 120 facing away from the interface layer 140. The p+-type silicon region 126 is configured to provide a pinned surface potential of the silicon layer 120. The diode arrangement further comprises a n+-type silicon region 128 at the first surface forming a node for read-out of collected electrons. The n+-type silicon region 128 is separated from the p+-type silicon region 126 and the n-type silicon 124 by a p-type silicon well 130.

The electrons transported to the silicon layer 120 may thus be collected in the n-type silicon region 124. The electrons may be prevented from reaching the n+-type silicon region 128 by a potential barrier. The potential barrier may be affected by a signal provided to a transfer gate 152 such that the potential barrier may be lowered upon the signal being provided to the transfer gate 152 and collected electrons may be transported to the n+-type silicon region 128 for read-out.

The silicon layer 120 may be formed by an n-type monocrystalline silicon substrate. The diode arrangement 122 may be formed in the silicon layer 120 in accordance with conventional semiconductor manufacturing technology for forming photodiode structures in silicon substrates.

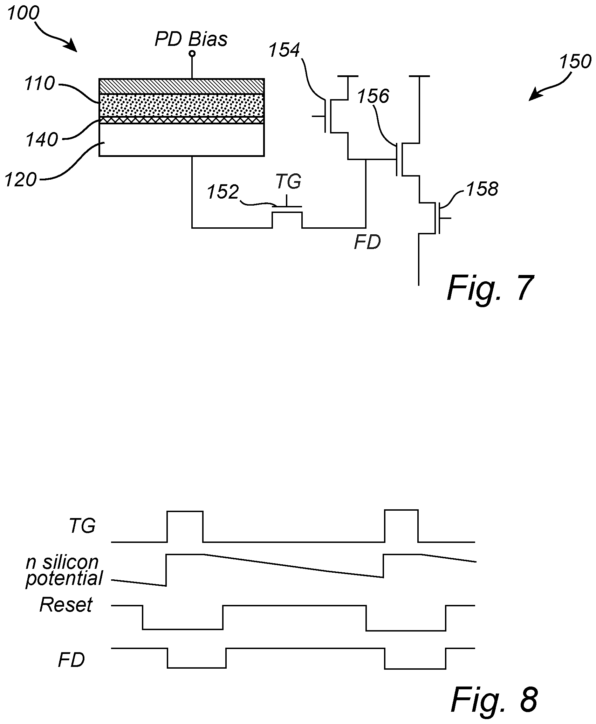

The silicon layer 120 may further be provided with integrated read-out circuitry 150 (see Fig. 7) for read-out of signals from the diode arrangement 122 such that signals representing detected incident light may be read out. The integrated read-out circuitry 150 may be provided using conventional semiconductor manufacturing technology and may be provided at the first surface of the silicon layer 120.

The silicon substrate may be thinned from a second surface opposite to the first surface after the forming of the read-out circuitry 150. This may ensure that electrons to be transported from a backside of the silicon layer 120 to the diode arrangement 122 may not need to be transported through a thick silicon layer. Thinning of the silicon substrate may also facilitate backside illumination of conventional photodiodes formed on the same silicon substrate as the device 100.

After the forming of the read-out circuitry 150 integrated with the silicon layer 120, the silicon layer 120 may be flipped and further processed to provide layers at the surface opposite from the first surface. The interface layer 140 may thus be formed on the silicon layer 120.

The interface layer 140 may be formed by at least one layer of hydrogenated amorphous silicon. The hydrogenated amorphous silicon may form a passivation layer on the silicon layer 120 for ensuring an interface with low surface state density.

A thickness of the layer of hydrogenated amorphous silicon may be smaller than 500 nm. For instance, the thickness of the layer may be smaller than 300 nm, such as smaller than 100 nm.

The interface layer 140 and any layer deposited on the interface layer 140 may be deposited using a relatively low temperature, so as not to affect already processed silicon transistors (forming the read-out circuitry 150) and the diode arrangement 122. Thus, the layer of hydrogenated amorphous silicon may for instance be formed on the silicon layer 120 using plasma-enhanced chemical vapor deposition (PECVD).

The active layer 110 may be formed on the interface layer 140. The active layer 110 may be formed of or comprise a material that is adapted to absorb light of a wavelength or range of wavelengths for which the device 100 is to be sensitive. The active layer 110 may comprise quantum dots, a perovskite material, or an organic semiconductor. The active layer 110 may be formed by deposition of material on the interface layer 140 for forming a thin film of the active layer 110. The active layer 110 may need to be formed at a low temperature (about 100 - 200 °C) and may for instance be deposited using spin coating, evaporation, or sputtering. Since the active layer 110 may need to be processed at a low temperature, any layer formed on the active layer 110 may also need to be formed at a low temperature.

A thickness of the active layer 110 may be smaller than 500 nm, such as smaller than 300 nm. The thickness of the active layer 110 may be larger than 10 nm, such as larger than 50 nm. For instance, the active layer 110 may have a thickness in a range of 10 - 500 nm, such as in a range of 50 - 300 nm.

The active layer 110 may, for example, comprise a quantum dot, such as a quantum dot based on lead sulfide (PbS), lead antimonide (PbSb), indium arsenide (InAs), indium antimonide (InSb), indium arsenide antimonide (InAsSb), silver telluride (AgTe), silver selenide (AgSe), silver sulphide (AgS), indium phosphide (InP), or cadmium selenide (CdSe).

Alternatively, the active layer 110 may comprise a perovskite material, such as metal halide perovskites of type ABXs, where A can be caesium, methylammonium and/or formamidinium, B is the metal and can be lead and/or tin, and X is the halogen and can be iodine, bromine, and/or chlorine.

According to yet another alternative, the active layer 110 may comprise an organic semiconductor, such as aluminum tris(guinolate) (Alq3), polyphenylene vinylene (PPV) derivatives, (4-(dicyanomethylene)-2-methyl-6-(4-dimethylaminostyryl)-4H-pyran (DCM), (poly(9,9'-dioctylfluorene-co-benzothiadiazole)) (FBBT), or (poly(2-methoxy-5-(2-ethyl-hexyloxy)-1,4-phenylene-vinylene) (MEH-PPV).

The hole transport layer 162 may be formed on the active layer 110. The hole transport layer 162 may be formed by a material suitable for fast transport of holes in the layer. The hole transport layer 162 may be formed by deposition of material on the active layer for forming a thin film of the hole transport layer 162.

A thickness of the hole transport layer 162 may be larger than 10 nm, such as larger than 50 nm. The thickness of the hole transport layer 162 may be smaller than 500 nm, such as smaller than 300 nm. For instance, the hole transport layer 162 may have a thickness in a range of 10 - 500 nm, such as in a range of 50 - 300 nm.

The hole transport layer 162 may for instance be formed by poly(3,4-ethylenedioxythiophene) polystyrene sulfonate (PEDOT:PSS), molybdenum oxide, nickel oxide, or poly(4-butylphenyl-diphenylamine) (poly-TPD).

The transparent conductive electrode 160 may be formed on the hole transport layer 162. The transparent conductive electrode 160 may be formed by a material being electrically conductive and further being transparent to the wavelengths of light to be detected by the device 100. For instance, the transparent conductive electrode 160 may be formed by indium tin oxide. Alternatively, the transparent conductive electrode 160 may be formed by silver or graphene. The transparent conductive electrode 160 may be formed by deposition of material on the hole transport layer 162.

A thickness of the transparent conductive electrode 160 may be dependent on the material of the transparent conductive electrode 160. If indium tin oxide is used, the transparent conductive electrode 160 may have a thickness larger than 100 nm and smaller than 500 nm, such as in a range of 200 - 400 nm. If silver is used, the transparent conductive electrode 160 may have a thickness of approximately 10 nm, such as in a range of 5 - 20 nm. If graphene is used, the transparent conductive electrode 160 may have a thickness of a few nm, such as smaller than 5 nm.

Referring now to Fig. 2, energy level of the conduction band of electrons along line a-a' in Fig. 1 is illustrated. As shown in Fig. 2, thanks to the interface layer 140, a smooth alignment of the conduction band energy is provided. Thus, the electrons generated by the active layer 110 will not experience large potential barriers in a path followed by the electrons going from the active layer 110 to the silicon layer 120.

The energy level of the conduction band may be strictly decreasing from the active layer 110 to the silicon layer 120. It should be realized that the energy level of the conduction band may be constant in some part of the path followed by the electrons. It should be further realized that the energy level of the conduction band may comprise a small increase of the energy level, such as an increase being smaller than 5 times a thermal voltage, such as 3 times a thermal voltage, at a temperature of 25°C.

As further shown in Fig. 2, the p+-type silicon region 126 provides a pinned surface potential forming a potential barrier to the electrons. Thus, the electrons are collected in the n-type silicon 124 during an integration time of the device 100.

Referring now to Fig. 3, energy level of conduction band of electrons within the silicon layer 110 along line b-b' in Fig. 1 is illustrated. Fig. 3 shows in a left part, the energy level of the conduction band when no signal is provided to the transfer gate 152 or the transfer gate 152 is low. Fig. 3 shows in a right part, the energy level of the conduction band when a signal is provided to the transfer gate 152 or the transfer gate 152 is high.

As shown in Fig. 3, the transfer gate 152 may control transfer of electrons between the n-type silicon 124 and the n+-type silicon region 128 forming the node for read-out of collected electrons. When the transfer gate 152 is low, the p-type silicon well 130 forms a potential barrier preventing electrons to be transported from the n-type silicon 124 to the n+-type silicon region 128. When the transfer gate 152 is high, the energy level of the conduction band in the p-type silicon well 130 is lowered such that electrons may be transported to the n+-type silicon region 128, which further has a lower energy level of the conduction band compared to the n-type silicon 124.

Thus, the transfer gate 152 provides a control of transport of collected electrons to the node for read-out.

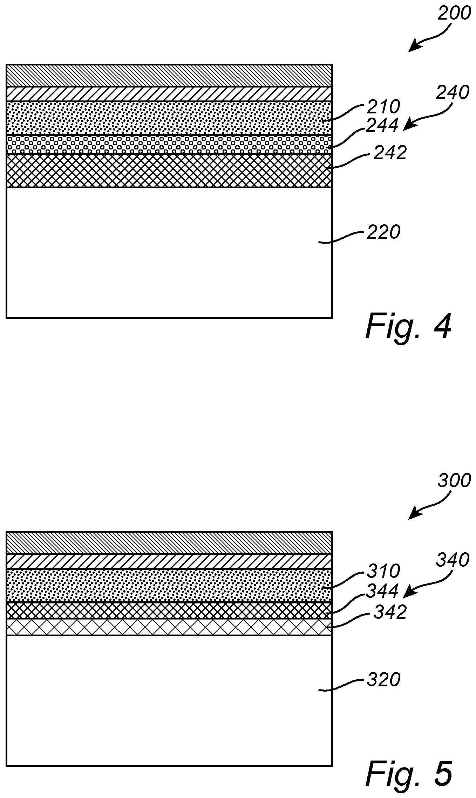

Referring now to Figs 4-6, details of alternative embodiments of the device will be described. For brevity and to avoid repetition, the below discussion of the alternative embodiments will mainly describe the differences to the device 100.

Fig. 4 shows a second embodiment of the device 200 for light detection. In the device 200, the interface layer 240 between the silicon layer 220 and the active layer 210 may comprise the passivation layer 242 formed by hydrogenated amorphous silicon and an additional passivation layer 244.

The additional passivation layer 244 may be configured to further passivate the surface of the silicon layer 220, so as to reduce surface state density of the surface of the silicon layer 220. The additional passivation layer 244 may also be configured to improve alignment of the conduction band of electrons to the energy level of the active layer 210.

In addition, it should be realized that the additional passivation layer 244 may also or alternatively form an electron transport layer between the active layer and the interface layer, wherein the electron transport layer is configured to facilitate transport of electrons from the active layer towards the interface layer.

It should be realized that an electron transport layer separate from the additional passivation layer may be provided. Alternatively, a single layer may both provide a function of additional passivation and electron transport.

The electron transport layer may thus be configured to provide fast transport of electrons from the active layer through the electron transport layer to the interface layer.

The additional passivation layer 244 and/or electrode layer may for instance be formed by titanium oxide, zinc magnesium oxide, PCBM, zinc oxide, or tin oxide. The additional passivation layer 244 may be formed on the passivation layer 242 and may thus be arranged between the passivation layer 242 and the active layer 210.

A thickness of the additional passivation layer 244 may be larger than 10 nm, such as larger than 30 nm. The thickness of the additional passivation layer 244 may be smaller than 300 nm, such as smaller than 100 nm. For instance, the additional passivation layer 244 may have a thickness in a range of 10 - 300 nm, such as in a range of 30 - 100 nm.

Referring now to Figs 5-6, different embodiments for achieving a p-n junction in the device will be described. As mentioned above, the p-n junction may be formed in the active layer or in an interface between the active layer and an adjacent layer.

Fig. 5 shows a third embodiment of the device 300 for light detection. In the device 300, the interface layer 340 between the silicon layer 320 and the active layer 310 comprises a first layer 344 facing the active layer 310 formed by hydrogenated amorphous silicon having a first level of n-doping and a second layer 342 formed by hydrogenated amorphous silicon being intrinsic or having a second level of n-doping smaller than the first level. The first level of n-doping may have a doping concentration range of 10¹⁶ - 10¹⁹ cm-³. The hydrogenated amorphous silicon being intrinsic or having a second level of n-doping may have a doping concentration smaller than 10¹⁶ cm⁻³.

The first layer 344 is thus arranged between the second layer 342 and the active layer 310.

This implies that a p-n junction may be formed at the interface between the active layer 310 and the first layer 344. The electrons generated by the active layer 310 may be swept by the p-n junction towards the silicon layer 320.

A thickness of each of the first layer 344 and the second layer 342 may be larger than 10 nm, such as larger than 30 nm. The thickness of each of the first layer 344 and the second layer 342 may be smaller than 300 nm, such as smaller than 100 nm. For instance, each of the first layer 344 and the second layer 342 may have a thickness in a range of 10 - 300 nm, such as in a range of 30 - 100 nm.

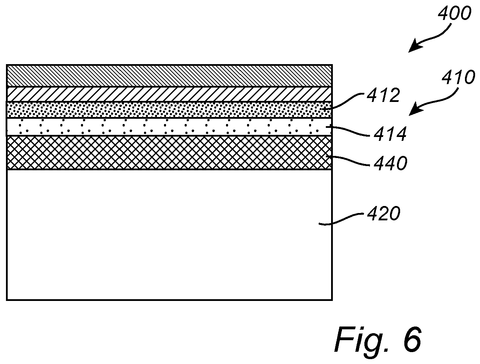

Fig. 6 shows a fourth embodiment of the device 400 for light detection. In the device 400, the active layer 410 comprises a first layer 412 and a second layer 414, wherein the second layer 414 is configured to face the interface layer 440 such that the second layer 414 is between the interface layer 440 and the first layer 412.

The first layer 412 comprises a p-type material and the second layer 414 comprises an n-type material for forming a p-n junction between the first layer 412 and the second layer 414. The electrons generated by the active layer 410 may be swept by the p-n junction towards the silicon layer 420.

The first layer 412 and the second layer 414 may for instance be provided by two different layers of quantum dots.

A thickness of each of the first layer 412 and the second layer 414 may be larger than 10 nm, such as larger than 50 nm. The thickness of each of the first layer 412 and the second layer 414 may be smaller than 500 nm, such as smaller than 300 nm.

Referring now to Fig. 7, a read-out circuitry 150 for read-out of signals representative of the incident light on the device 100 will be described. It should be realized that the read-out circuitry 150 may be used with the device according to any of the above-described embodiments.

The read-out circuitry 150 illustrated in Fig. 7 may have a common structure and operation similar to conventional complementary metal-oxide-semiconductor (CMOS) image sensors.

The device 100 may thus utilize read-out circuitry 150 that is commonly used for reading signals from CMOS image sensors but for read-out of a signal that represents light detected using the active layer 110. Thus, the device 100 may not be limited to detecting wavelengths of light for which silicon is sensitive. Rather, the device 100 may be used for detecting wavelengths of light selected from a broad spectrum. The device 100 may be configured to detect a wavelength or wavelength range of light within a spectrum including ultraviolet light, visible light, and infrared light. In particular, the active layer 110 may be sensitive for detection of light in short-wavelength infrared (SWIR) range. This may be particularly advantageous, since silicon is not sensitive to SWIR light, and conventional CMOS image sensors are thus not able to detect SWIR light.

As mentioned above, the device 100 may further be configured to detect light by backside illumination. The device 100 may thus further be arranged for detecting light in a manner that may also be used for conventional CMOS image sensors.

The read-out circuitry 150 may thus be provided at a surface of the silicon layer 120 facing away from the active layer 110. The read-out circuitry 150 may further be associated with wiring layers providing electrical connection to the read-out circuitry 150. The device 100 being configured to detect light by backside illumination implies that the device 100 is configured to receive incident light at the active layer 110 such that the light is incident into the active layer 110 from a surface of the active layer 110 facing away from the silicon layer 120. This implies that the device 100 may be very sensitive to incident light as light will not be lost by having to pass layers, such as wiring layers, before reaching the active layer 110.

The read-out circuitry 152 comprises a transfer gate 152 controlling transfer of charges to a floating diffusion node. The floating diffusion node may be formed by the n+-type silicon region 128. Thus, the transfer gate 152 may control transfer of charges in the diode arrangement 122 in the silicon layer 120.

The read-out circuitry 150 may further comprise additional transistors for read-out of the signal from the device 100. These may correspond to transistors used in conventional CMOS image sensors.

Thus, the read-out circuitry 150 may comprise a reset transistor 154 for controlling reset of the floating diffusion node. The reset transistor 154 may reset the floating diffusion node to empty the floating diffusion node on charges between different signals being read out from the device 100. The read-out circuitry 150 may further comprise a source follower transistor 156. The charge-to-voltage converted signal at the floating diffusion node may be buffered by the source follower transistor 156. The read-out circuitry 150 may further comprise a row select transistor 158. This is used for read-out of signals in an array of devices. The row select transistor 158 may connect and disconnect the device to a column output line to select which device 100 in the array that is to be read out.

Referring now to Fig. 8, an operational timing diagram of the device 100 is discussed.

The operational timing diagram shows a TG signal to the transfer gate 152, a potential in the n-type silicon 124, a Reset signal to the reset transistor 154, and a potential at the floating diffusion (FD) node which corresponds to the n+-type silicon region 128.

Integrated electrons in the n-type silicon 124 are transferred to the FD node by the TG signal going high. The transfer of electrons to the FD node implies that all electrons are moved from the n-type silicon 124 to the FD node for resetting an amount of electrons within the n-type silicon 124. When the TG signal goes low again, electrons again start to integrate in the n-type silicon 124. Therefore, the potential of the n-type silicon 124 is seen to decrease in Fig. 8, when the TG signal goes low.

The FD node is reset based on the Reset signal, which causes the FD node to be emptied. The Reset signal is high and goes low shortly before the TG signal goes high. The potential at the FD node is set to a reset level by the Reset signal going high. The potential at the FD node is then held at the reset level until the TG signal goes high (after the Reset signal turned low). The potential at the FD node is then held at a signal level representing the incident light on the device 100 until the Reset signal goes high again (after the TG signal turned low).

The read-out circuitry 150 may be configured to sample the FD node before and after transferring of electrons to the FD node by the TG signal going high. Thus, correlated double sampling may be used for enabling canceling of noise to ensure that a signal from the device 100 representing the incident light may be read out with a very high signal-to-noise ratio.

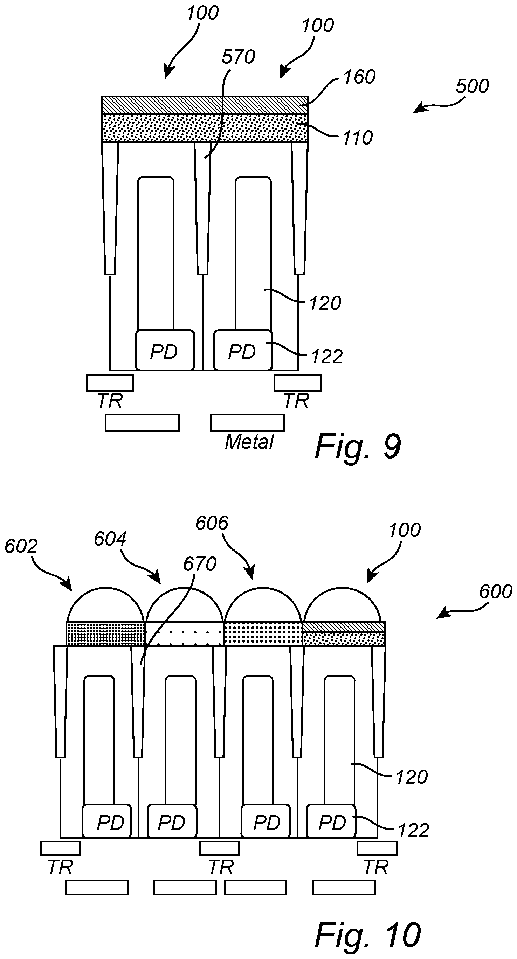

Referring now to Figs 9-10, image sensors comprising a plurality of devices according to any of the above-described embodiments are disclosed.

In Fig. 9, an image sensor 500 comprising a plurality of devices 100 are indicated. It should however be realized that the device according to any one of the above-described embodiments are disclosed. Fig. 9 shows a cross-section of two devices 100 arranged next to each other. However, it should be realized that the array may comprise a large number of devices arranged in rows and columns. Each of the devices 100 may form a light detecting unit for detecting light and may also be referred to as a pixel.

As shown in Fig. 9, adjacent devices 100 may share one or more layers. For instance, the active layer 110 and the electrode 160 may extend over a plurality of devices 100. However, it should be realized that each device 100 may form a separate stack of layers. This may be particularly important for separately controlling the devices 100 such that different signals to electrodes 160 of different devices 100 are to be provided. Also, the devices 100 may be configured to be sensitive to different wavelengths of light by the active layer 110 being formed by different materials or having different material characteristics in different devices 100. This would mean that the active layer 110 of different devices 100 in the array would need to be separate.

The electrons generated in the active layer 110 of an individual device 100 is to be separately read out for providing separate signals from separate light detecting units. The interface layer 140 and the silicon layer 120 may therefore need to have separate parts for different devices 100. This may be achieved by having a deep trench isolation (DTI) 570 arranged between adjacent devices and extending in a direction perpendicular to extension of the layers in the devices 100. The DTI may extend a distance corresponding to a portion of the silicon layer 120 or through the entire silicon layer 120 for preventing crosstalk between adjacent devices 100.

In Fig. 10, an image sensor 600 is shown, wherein the image sensor comprises an array of light detecting units, wherein the light detecting units include light detecting units formed by devices 100 according to any of the above-described embodiments but also include visible light detecting units 602, 604, 606 formed in a manner corresponding to light detecting units of conventional CMOS image sensors.

Thus, the visible light detecting units 602, 604, 606 may be associated with different filters for controlling the wavelength or wavelength range of visible light to be detected by the visible light detecting units. For instance, the filters may be configured to provide detection of green, red, and blue light, respectively, by the visible light detecting units 602, 604, 606. The filters may selectively pass light of a desired wavelength range. The light passing the filters may propagate through a silicon layer to reach a pinned photodiode. The visible light detecting units 602, 604, 606 may thus comprise a similar structure corresponding to the silicon layer 120 of the device 100.

Similar to the image sensor shown in Fig. 9, deep trench isolations (DTI) 670 may be arranged between adjacent light detecting units and extending in a direction perpendicular to extension of the layers in the light detecting units.

The light detecting unit formed by the device 100 may be configured to detect light in SWIR range for allowing the image sensor to provide imaging in a spectral range including visible light and SWIR light.

Fig. 10 illustrates that the image sensor 600 may be configured to detect light in a plurality of wavelength bands, here in four different wavelength bands. Thus, a unit cell comprising one or more light detecting units dedicated to each of the plurality of wavelength bands may be defined, such that the unit cell may provide a spectral resolution of imaging. It should be realized that the light detecting units 602, 604, 606, 100 may not be arranged in a line within the unit cell but may rather be arranged in a group that may extend over more than one row and more than one column in the array, such as in a 2x2 arrangement. The unit cells may be repeated across the array to provide imaging with spatial and spectral resolution.

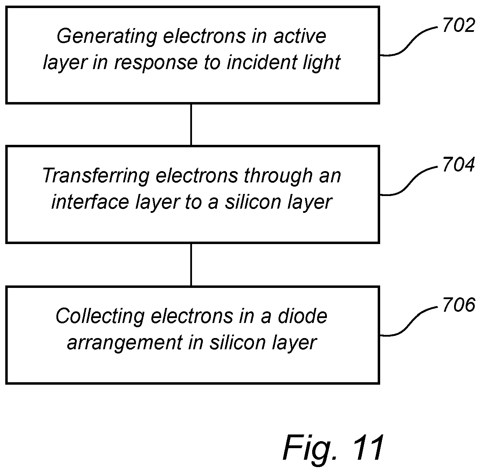

Referring now to Fig. 11, a method for light detection will be briefly described.

The method comprises generating 702 electrons in an active layer in response to incident light on the active layer. The active layer may be adapted to be sensitive to a wavelength of light within a broad spectrum of wavelengths. Thus, the incident light may have a wavelength within a broad spectrum, including ultraviolet light, visible light, and infrared light. The electrons may be generated at or in close vicinity to a p-n junction such that the electrons may be swept away from the p-n junction.

The method further comprises transferring 704 the electrons through an interface layer to a silicon layer. The interface layer is configured to provide an alignment of a conduction band of electrons between an energy level of the active layer and an energy level of the silicon layer for facilitating transport of the generated electrons from the active layer to the silicon layer. Thus, the electrons may be efficiently transferred to the silicon layer experiencing no large potential barriers in a path between the active layer and the silicon layer.

The method further comprises collecting 706 the electrons in a diode arrangement in the silicon layer. The method may thus use the diode arrangement in the silicon layer for efficient read-out of the collected electrons using conventional technology implemented in silicon.

In the above the inventive concept has mainly been described with reference to a limited number of examples. However, as is readily appreciated by a person skilled in the art, other examples than the ones disclosed above are equally possible within the scope of the inventive concept, as defined by the appended claims.

## Claims

1. A device (100; 200; 300; 400) for light detection, wherein the device (100; 200; 300; 400) comprises:
an active layer (110; 210; 310; 410) configured to generate electrons in response to incident light on the active layer (110; 210; 310; 410);
a silicon layer (120; 220; 320; 420) comprising a diode arrangement (122) configured for collection of the electrons generated by the active layer (110; 210; 310; 410);
an interface layer (140; 240; 340; 440) arranged between the active layer (110; 210; 310; 410) and the silicon layer (120; 220; 320; 420), wherein the interface layer (140; 240; 340; 440) is configured to provide an alignment of a conduction band of electrons between an energy level of the active layer (110; 210; 310; 410) and an energy level of the silicon layer (120; 220; 320; 420) for facilitating transport of the generated electrons from the active layer (110; 210; 310; 410) to the silicon layer (120; 220; 320; 420).

2. The device according to claim 1, wherein the interface layer (140; 240; 340; 440) comprises a passivation layer formed by hydrogenated amorphous silicon.

3. The device according to claim 2, wherein the interface layer (240) further comprises an additional passivation layer (244) between the passivation layer (242) and the active layer (210), wherein the additional passivation layer (244) comprises titanium oxide, zinc magnesium oxide, [6,6]-phenyl-C61-butyric acid methyl ester, PCBM, zinc oxide, or tin oxide.

4. The device according to claim 2 or 3, wherein the passivation layer (340) comprises a first layer (344) facing the active layer formed by hydrogenated amorphous silicon having a first level of n-doping and a second layer (342) formed by hydrogenated amorphous silicon being intrinsic or having a second level of n-doping smaller than the first level, wherein the first layer is between the second layer and the active layer

5. The device according to any one of the preceding claims, wherein the active layer (110; 210; 310; 410) comprises quantum dots, a perovskite material, or an organic semiconductor.

6. The device according to any one of the preceding claims, wherein the active layer (410) comprises a first layer (412) and a second layer (414), wherein the second layer (414) is configured to face the interface layer (440), wherein the first layer (412) comprises a p-type material and the second layer (414) comprises an n-type material for forming a p-n junction between the first layer (412) and the second layer (414).

7. The device according to any one of the preceding claims, wherein the silicon layer (120) comprises n-type silicon (124), a p+-type silicon region (126) at a first surface of the silicon layer (120) facing away from the interface layer (140), wherein the p+-type silicon region (126) is configured to provide a pinned surface potential of the silicon layer (120), and a n+-type silicon region (128) at the first surface forming a node for read-out of collected electrons, wherein the n+-type silicon region (128) is separated from the p+-type silicon region (126) and the n-type silicon (124) by a p-type silicon well (130).

8. The device according to claim 7, further comprising read-out circuitry (150), wherein the read-out circuitry (150) comprises a transfer gate (152) configured to control reset of the diode arrangement (122) and transfer of charges from the n-type silicon (124) to the n+-type silicon region (128).

9. The device according to any one of the preceding claims, further comprising an electron transport layer between the active layer and the interface layer, wherein the electron transport layer is configured to facilitate transport of electrons from the active layer towards the interface layer.

10. The device according to any one of the preceding claims, further comprising a transparent electrode (160) above the active layer (110; 210; 310; 410) such that the active layer (110; 210; 310; 410) is arranged between the transparent electrode (160) and the silicon layer (120; 220; 320; 420).

11. The device according to any one of the preceding claims, wherein the device (100; 200; 300; 400) is configured to detect light by backside illumination.

12. The device according to any one of the preceding claims, wherein the active layer (110; 210; 310; 410) is sensitive for detection of light in short-wavelength infrared, SWIR, range.

13. An image sensor (500; 600), comprising an array of light detecting units, wherein each of a plurality of light detecting units in the array is formed by the device (100) according to any one of the preceding claims.

14. The image sensor according to claim 13, wherein the array of light detecting units further comprises a plurality of visible light detecting units (602, 604, 606), wherein each visible light detecting unit (602, 604, 606) comprises a photodiode formed in a silicon layer for detecting visible light.

15. A method for light detection, said method comprising:
generating (702) electrons in an active layer in response to incident light on the active layer;
transferring (704) the electrons through an interface layer to a silicon layer;
collecting (706) the electrons in a diode arrangement in the silicon layer;
wherein the interface layer is configured to provide an alignment of a conduction band of electrons between an energy level of the active layer and an energy level of the silicon layer for facilitating transport of the generated electrons from the active layer to the silicon layer.
